# EUROPEAN PATENT APPLICATION

(11) **EP 3 499 558 A1**
(43) Date of publication of application: **19.06.2019**
(21) Application number: 17839238.7
(22) Date of filing: 27.07.2017
(51) Int. Cl.: H01L 23/12, B23K 20/12, C04B 37/02, H01L 23/13, H01L 23/36, H01L 25/07, H01L 25/18

(54) **SEMICONDUCTOR MODULE AND METHOD FOR MANUFACTURING SAME**

(30) Priority: 10.08.2016 JP 2016157443
(71) Applicant: Kabushiki Kaisha Toshiba, Minato-ku Tokyo 105-8001 (JP)
(72) Inventor: IGUCHI, Tomohiro, Tokyo 105-8001 (JP); TOMIOKA, Taizo, Tokyo 105-8001 (JP)
(74) Representative: Hoffmann Eitle
(86) International application number: PCT/JP2017/027238
(87) International publication number: WO 2018/030165

(57) **Abstract**

A semiconductor module (100) includes a semiconductor device (11), a metal base (20), a substrate (10), and a metal layer. The metal base (20) includes a stirring part (21). The substrate (10) is positioned between the semiconductor device (11) and the metal base (20). The metal layer is positioned between the metal base (20) and the substrate (10). The metal layer contacts the stirring part (21).

## Description

### [Technical Field]

Embodiments relate to a semiconductor module and a method for manufacturing the same.

### [Background Art]

A semiconductor module is a semiconductor device including multiple semiconductor power devices. The semiconductor module is also called a power module, which is used for, for example, an inverter, a converter, a regulator or the like. The semiconductor module deals with large electric power. Thus, countermeasures against heat generation are necessary. The semiconductor module includes a cooling plate such as a metal base in order to diffuse the heat generated by the power devices. The cooling plate is generally made of copper (Cu). The Cu cooling plate is bonded to a ceramic substrate with solder, on which the power devices are mounted. However, the heat resistance of the solder is high, and often reduces the heat diffusion. Moreover, Cu is relatively heavy, and is an obstacle to weight saving of the semiconductor module. The semiconductor module is desired to be light in weight and superior in heat diffusion.

### [Patent Literature]

[Patent Literature 1] JP 2014-179547 A (Kokai)
[Patent Literature 2] JP 2005-28378 A (Kokai)
[Patent Literature 3] Japanese Patent No. 4404052

### [Summary of Invention]

The embodiments provide semiconductor modules and a method for manufacturing the same, which are light in weight and superior in heat diffusion.

According to an embodiment, a semiconductor module includes a semiconductor device, a metal base, a substrate, and a metal layer. The metal base includes a stirring part. The substrate is positioned between the semiconductor device and the metal base. The metal layer is positioned between the metal base and the substrate. The metal layer contacts the stirring part.

### [Brief Description of Drawings]

FIG. 1 is a schematic cross-sectional view showing one example of a semiconductor module according to a first embodiment;
FIG. 2 an enlarged view of a portion in a frame A denoted by a broken line in FIG. 1;
FIGS. 3A to 3F are schematic cross-sectional views showing one example of a method for manufacturing the semiconductor module according to the first embodiment;
FIG. 4 is a schematic cross-sectional view showing a semiconductor module of a first reference example;
FIGS. 5A and 5B are schematic cross-sectional views showing a bonded portion of a metal base and a first metal layer of a second reference example;
FIGS. 6A and FIG. 6B are schematic cross-sectional views showing a bonded portion of a metal base and a first metal layer according to a second embodiment;
FIG. 7 is a schematic cross-sectional view showing one example of a method for manufacturing a semiconductor module according to the second embodiment;
FIG. 8 is a schematic cross-sectional view showing one example of a method for manufacturing a semiconductor module according to a third embodiment; and
FIG. 9 is a schematic cross-sectional view showing one example of a method for manufacturing a semiconductor module according to a fourth embodiment.

### [Embodiments of Invention]

Embodiments will be described hereinafter with reference to the accompanying drawings. In the drawings, similar components are marked with similar number or symbol.

### (First embodiment)

### <Semiconductor module>

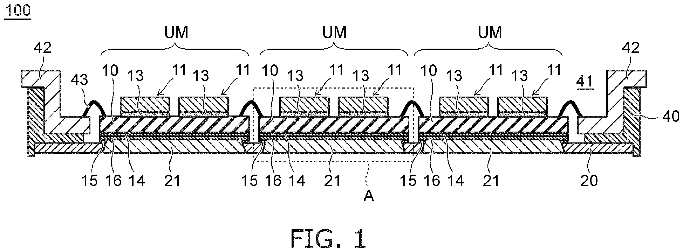

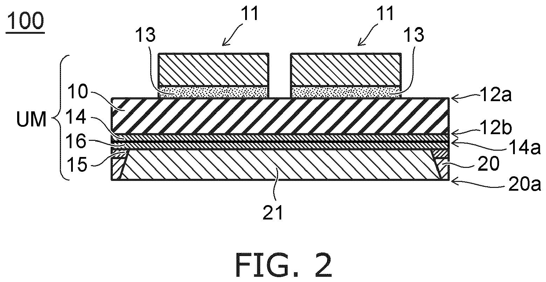

FIG. 1 is a schematic cross-sectional view showing one example of a semiconductor module according to a first embodiment. FIG. 2 is an enlarged view of a portion in a frame A denoted by a broken line in FIG. 1.

As shown in FIG. 1 and FIG. 2, a semiconductor module 100 includes a substrate 10, a metal base 20 and a case 40. The substrate 10 is bonded to the metal base 20. The metal base 20 is bonded to the case 40.

The substrate 10 is, for example, an insulating substrate made of ceramic. The substrate 10 includes multiple semiconductor devices 11 on a device mounting surface 12a. The semiconductor devices 11 include a power device. The power device is, for example, IGBT, a power MOS transistor, a bipolar transistor, and a diode or the like. An electrode pattern (not shown) is provided on the device mounting surface 12a, for example. The electrode pattern is, for example, made of Cu. The semiconductor devices 11 are bonded to the electrode pattern, for example, by a solder layer 13. The electrode pattern may be an interconnection pattern.

The substrate 10 includes a first metal layer 14 on a back surface 12b. The back surface 12b is a surface opposite to the device mounting surface 12a. The first metal layer 14 includes a first metal. The first metal is, for example, copper (Cu). The first metal layer 14 of the embodiment is, for example, Cu or CuW (alloy of Cu and tungsten W).

A second metal layer 15 is provided on a bonding surface 14a of the first metal layer 14, for example, via a third metal layer 16. The second metal layer 15 includes a second metal. The second metal is different from the first metal. When the first metal is Cu, the second metal is, for example, aluminum (Al). A melting point of the second metal is, for example, lower than a melting point of the first metal. The second metal has, for example, hardness lower than the hardness of the first metal.

The second metal layer 15 is formed on the third metal layer 16, for example, by using a chemical vapor deposition (CVD) method or a physical vapor deposition (PVD) method. When the second metal is Al, a gas including Ai precursor gas including Al is used as a source material gas in the CVD method. An Al target including Al is used as a source material target in the PVD method.

Third metal layer 16 includes a third metal different from the first metal and the second metal. The third metal layer 16 serves as an adhesion layer to improve the adhesiveness between the first metal layer 14 and the second metal layer 15. The third metal layer 16 is, for example, selected from active metals. The active metals are titanium (Ti), chromium (Cr) or the like. The third metal layer 16 of the first embodiment is Ti. The third metal layer 16 is formed by using the CVD method or the PVD method in the same manner as the second metal layer 15.

The third metal layer 16 may be provided as necessary. Thus, it is possible to omit the third metal layer 16. When the third metal layer 16 is not provided, the second metal layer 15 is directly provided on the first metal layer 14. When the third metal layer 16 is provided between the first metal layer 14 and the second metal layer 15, it is possible to achieve the advantage of the improved adhesiveness in comparison with the case of not providing the third metal layer 16.

The metal base 20 is provided on the second metal layer 15. The metal base 20 includes the same second metal as the second metal layer 15. In the first embodiment, the metal base 20 is made of Al. The metal base 20 is, for example, a cooling plate. The cooling plate diffuses the heat generated by the semiconductor devices 11.

The metal base 20 is bonded to the second metal layer 15 by friction stir welding. Thus, a stirring part 21 is provided in the metal base 20. The stirring part 21 is, for example, formed through the metal base 20 to a surface of the second metal layer 15. The stirring part 21 may reach the first metal layer 14 through the second metal layer 15 and the third metal layer 16.

In the first embodiment, an outer surface 20a of the metal base 20 is, for example, grounded so that the stirring part 21 is exposed at the outer surface 20a. The outer surface 20a is a surface opposite to a bonding surface of the metal base 20. The outer surface 20a is grounded, and thus, the metal base 20 is thinned together with smoothing the stirring part 21 in the outer surface 20a and unevenness generated around the stirring part 21.

A structure body including the substrate 10 to the third metal layer 16 is referred to as a unit module UM. As shown in FIG. 1 and FIG. 2, the semiconductor module 100 of the first embodiment includes, for example, three unit modules UM on the metal base 20. The number of the unit modules UM is arbitrary.

The case 40 is, for example, made of resin. The case 40 includes a housing part 41. The housing part 41 houses the unit module UM. The unit module UM is housed in the housing part 41, which is in a state of being provided on the metal base 20. The metal base 20 is fixed to the case 40.

The case 40 includes an external terminal 42. The external terminal 42 is electrically connected to the unit module UM via a wiring 43. The unit modules UM are electrically connected to each other via the wiring 43 as necessary.

### <Method for manufacturing the semiconductor module>

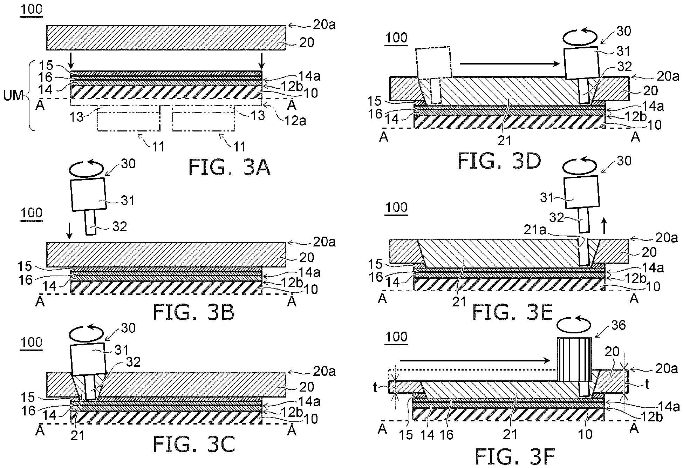

FIGS. 3A to 3F are cross-sectional views showing one example of a method for manufacturing the semiconductor module according to the first embodiment. Cross sections shown in FIGS. 3A to 3F correspond to, for example, the cross section shown in FIG. 2. In FIGS 3A to 3F, the unit module UM is shown in the flipped state as upside down.

As shown in FIG. 3A, the first metal layer 14 is formed on the back surface 12b of the substrate 10. The first metal layer 14 is formed by depositing, for example, Cu on the back surface 12b by using the CVD method or the PVD method. Then, the third metal layer 16 is formed on the bonding surface 14a of the first metal layer 14. The third metal layer 16 is formed by depositing, for example, Ti on the bonding surface 14a by using the CVD method or the PVD method. The second metal layer 15 is formed on the third metal layer 16. The third metal layer 16 is formed by depositing, for example, Al on the third metal layer 16 by using the CVD method or the PVD method. Next, the semiconductor devices 11 are bonded onto the device mounting surface 12a of the substrate 10 via the solder layer 13.

The metal base 20 is provided to contact the first metal layer 14 via the second metal layer 15 and the third metal layer 16. This contacting process may be performed before the semiconductor devices 11 are mounted on the device mounting surface 12a. In FIGS. 3A to 3f, the illustration of parts under the A-A line is omitted.

Next, as shown in FIGS. 3B and 3C, a friction stir welding tool 30 is moved above the metal base 20. The friction stir welding tool 30 includes a shoulder 31 and a probe pin 32. The probe pin 32 protrudes from the shoulder 31. The probe pin 32 is pointed toward the outer surfaced 20a of the metal base 20. The friction stir welding tool 30 opposes to the metal base 20, while being inclined to the outer surface 20a of the metal base 20. The inclination is called as the advancing angle.

Next, the friction stir welding tool 30 is run into the metal base 20 toward the second metal layer 15 while being rotated. When the friction stir welding tool 30 being rotated is run into the metal base 20, the metal base 20 is softened by frictional heat, and plastic flow is generated around the friction stir welding tool 30 by the rotation of the friction stir welding tool 30.

A reference numeral "21" in FIG. 3C represents the portion in which the "plastic flow" is generated. In the specification, the portion where the plastic flow is generated is referred to as the "stirred part". Hereinafter, the portion denoted by the reference numeral "21" is referred to as the stirred part 21. A penetration depth of the probe pin 32 is controlled to reach in the vicinity of the second metal layer 15 such that the tip of the probe pin 32 reaches the second metal layer 15 or the stirring part 21 contacts the second metal layer 15. The stirring part 21 is formed, for example, from the second metal layer 15 to the outer surface 20a of the metal base 20. The stirring part 21 may reach the third metal layer 16 through the second metal layer 15. Furthermore, the stirring part 21 may reach the first metal layer 14 through the second metal layer 15 and the third metal layer 16.

Next, as shown in FIG. 3D, the metal base 20 is welded by the friction stirring to the second metal layer 15 by using the friction stir welding tool 30. In the first embodiment, for example, the friction stir welding tool 30 rotated is run into the metal base 20, and is moved along, for example, the bonding surface 12b. Thereby, the metal base 20 is welded by the friction stirring to the second metal layer 15.

Next, as shown in FIG. 3E, the friction stir welding tool 30 is drown out form the metal based 20. Then, the bonding of the metal base 20 and the first metal layer 15 is completed. The friction stir welding tool 30 is removed, leaving a hole 21a as a vestige of the drawing.

Next, as shown in FIG. 3F, the outer surface 20a of the metal base 20 is ground using a grinding tool 36. The grinding tool 36 may be a cutting tool. The outer surface 20a of the metal base 20 is ground by the grinding using the grinding tool 36 and the cutting using the cutting tool. Thereby, the unevenness generated at the stirring part 21 and around the stirring part 21 is smoothed in the outer surface 20a. Along with this, a thickness "t" of the metal base 20 is thinned.

The semiconductor module 100 according to the first embodiment can be manufactured by such as a manufacturing method shown in FIGS. 3A to 3F.

### <Comparison of reference examples with embodiments>

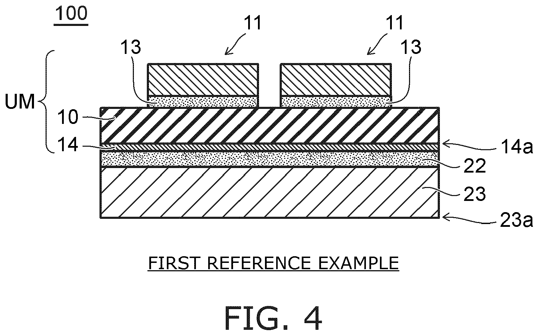

FIG. 4 is a schematic cross-sectional view showing a semiconductor module of a first reference example. The cross section shown in FIG. 3 corresponds to the cross section shown in FIG. 2.

### «First reference example»

As shown in FIG. 4, the first reference example is different from the first embodiment as follows:
Bonding of the unit module UM and a metal base 23 is bonding via a solder layer 22; and
the metal base 23 is made of Cu, or is made of Cu and plated with Ni, or is made of AiSiC and plated with Ni.

A thermal conductivity λ of "solder" is generally low. That is, "solder" is hard to pass heat. Therefore, the thermal resistance Rth of the solder layer 22 becomes large. For example, the solder used for the reference example has the thermal conductivity λ of about 30 (W/mK). According to the inventor's estimation, the solder layer 22 has the thermal resistance Rth of about 0.06 to 0.07 (K/W).

The thermal conductivity λ of "Cu" is about 398 (W/mK). According to the inventor's estimation, a thermal resistance Rth of the metal base 23 is about 0.03 to 0.04 (K/W).

A thermal resistance Rth (14-23) between a bonding surface 14a of the first metal layer 14 and an outer surface 23a of the metal base 23 is estimated as follows:
Rth (14 to 23) ≈ 0.09 to 0.11 (K/W)

### «First embodiment»

As shown in FIG. 2, the second metal layer 15a corresponds to the solder layer 22 in the first embodiment. The second metal layer 15 is Al. The metal base 20 is made of Al.

The thermal conductivity λ of "Al" is about 236 (W/mK). According to the inventor's estimation, the thermal resistance Rth of the second metal layer 15 is about 0.008 to 0.009 (K/W), and the thermal resistance Rth of the metal base 20 is about 0.05 to 0.06 (K/W). The reason why Rth of the second metal layer 15 is different from Rth of the metal base 20 is that a thickness of the second metal layer 15 is different from as thickness of the metal base 20. The thickness of the second metal layer 15 is thinner than the thickness of the metal base 20.

A thermal resistance Rth (14 to 20) between the bonding surface 14a of the first metal layer 14 and the outer surface 20a of the metal base 20 in the first embodiment is estimated as follows:
Rth (14 to 20) ≈ 0.058 to 0.069 (K/W)

However, the estimations described above correspond to the case without the third metal layer 16. As shown in FIG. 1 and FIG. 2, when the third metal layer 16 is provided, the third metal layer 16 has a thin thickness similar to the second metal layer 15. Thus, the thermal resistance Rth of the third metal layer 16 can be suppressed, for example, to be not more than 0.01 in the same manner with the second metal layer 15.

The thermal conductivity λ of "Al" is lower than the thermal conductivity λ of "Cu". Thus, the thermal resistance Rth of the metal base 20 in the first embodiment, for example, becomes high comparing with the thermal resistance Rth of the metal base 23 of the first reference example.

The metal base 20 of the first embodiment is directly bonded to the first metal layer 14 using, for example, the friction stir welding. Thereby, it is possible to omit the solder layer 22.

According to the first embodiment, since the solder layer 22 can be omitted, the thermal resistance (14 to 20) between the bonding surface 14a of the first metal layer 14 and the outer surface 20a of the metal base 20 can be suppressed to be low comparing with the first reference example. As a result of the thermal resistance (14-20), which can be suppressed to be low, the heat diffusion of the semiconductor module 100 is improved in comparison with the first reference example.

The specific gravity of "Cu" is about 8.5. The specific gravity of "Al" is about 2.7. "Al" has weight lighter than "Cu". Therefore, the metal base 20 of the first embodiment may be lighter in weight comparing with the metal base 23 of the first reference example. As a result of reduction in weight of the metal base 20, it is possible to make the semiconductor module 100 lighter in weight in comparison with the first reference example.

Furthermore, the outer surface 20a of the metal base 20 of the first embodiment is ground. In contrast, the outer surface 23a of the metal base 23 of the first reference example is not ground. In the first reference example, the bonding to the first metal layer 14 is performed via the solder layer 21 interposed. When the outer surface 20a of the metal base 20 is ground, the metal base 20 has the thinner thickness. Grinding the outer surface 20a is advantageous for weight saving of the metal base 20. Moreover, it is also advantageous for further reduction of the thermal resistance Rth of the metal base 20.

As described above, the semiconductor module that is light in weight and has superior heat diffusion and the manufacturing method thereof can be provided according to the first embodiment.

In the first embodiment, the metal base 20 is welded using friction stirring to the first metal layer 14 via the second metal layer 15. It may be possible to omit the second metal layer 15. In the case without the second metal layer 15, for example, the metal base 20 is directly welded using friction stirring to the first metal layer 14. When the metal base 20 welded using friction stirring to the first metal layer 14 via the second metal layer 15 interposed, however, the following advantages can be further obtained.

### «Second reference example»

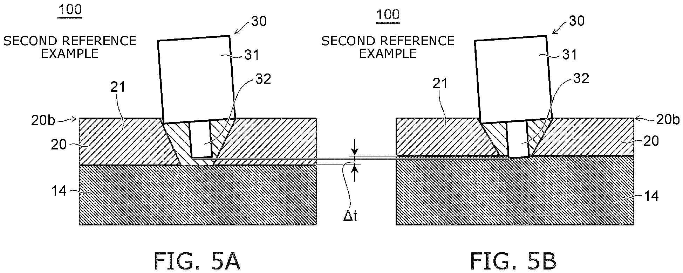

FIGS. 5A and 5B are schematic cross-sectional views showing a bonding portion of the metal base 20 and the first metal layer 14 in the second reference example.

As shown in FIG. 5A, for example, when the metal base 20 is directly contacted to the first metal layer 14, the tip of the probe pin 32 must be positioned inside the metal base 20. Since a slight distance may be provided between the tip of the probe pin 32 and the first metal layer 14, the control thereof is difficult. Thus, it is difficult, for example, in each of the semiconductor modules 100 to achieve reproducible uniformity in the heterogeneous bonding of metals using the friction stir welding.

For example, the first metal layer 14 shown in FIG. 5B has a thickness variation "Δt" comparing with the semiconductor module 100 shown in FIG. 5B. There is assumed to be no error in the penetration depth of the friction stir welding tool 30 in both cases of FIGS. 5A and 5B. In this case, whereas the tip of the probe pin 32 is positioned inside the metal base 20 in the semiconductor module 100 shown in FIG. 5A, the tip of the probe pin 32 reaches the inside of the first metal layer 14 in the semiconductor module 100 shown in FIG. 2B.

Thus, in the second reference example, even if the friction stir welding tool 30 is accurately controlled, it is difficult in each of the semiconductor modules 100 to achieve reproducible uniformity in the heterogeneous bonding of metals.

In the second reference example, the metal base 20 is bonded to the first metal layer 14 while generating an intermetallic compound. An amount of the intermetallic compound generated depends on a distance between the tip of the probe pin 32 and the first metal member 10. The amount of the intermetallic compound generated, for example, affects "bonding strength" of the first metal layer 14 and the metal base 20.

In the reference example, it is difficult to achieve reproducible uniformity in the heterogeneous bonding of metals, and thus, variation of the "bonding strength" is easily become large between the first metal layer 14 and the metal base 20.

Moreover, in the reference example shown in FIG. 5B, the tip of the probe pin 32 reaches the inside of the first metal layer 14. The first metal layer 14 is a harder metal than the metal base 20. Thus, the probe pin 32 is easily worn out.

### «First embodiment»

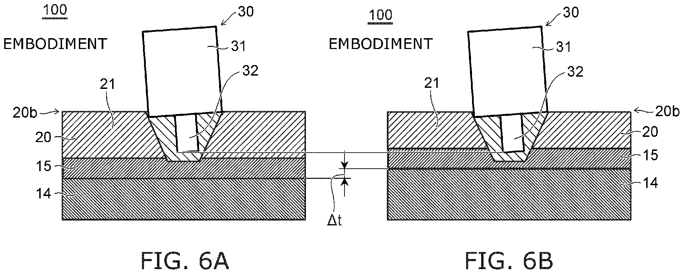

FIGS. 6A and 6B are schematic views showing a bonding portion between the base metal 10 and the first metal layer 14 according to the first embodiment.

Contrary to the second reference example, in the first embodiment, the metal base 20 contacts the first metal layer 14 with the second metal layer 15 interposed. The tip of the probe pin 32 is positioned inside the metal base 20 in the same manner with the second reference example. Even if the thickness variation Δt occurs in the first metal layer 14 in the same manner with the second reference example as shown in FIGS. 6A and 6B, the tip of the probe pin 32 can be kept at the position in the second metal layer 15.

The second metal layer 15 is, for example, an alloy including the second metal or the same metal as the metal base 20. For example, when the metal base 20 is Al, the second metal layer 15 is also Al. Thereby, when the distance is changed between the tip of the probe pin 32 and the first metal layer 14, variation of "bonding strength" may be avoided to occur between the first metal layer 14 and the metal base 20 comparing with the second reference example.

According to the first embodiment, it is possible in the semiconductor modules 100 to reduce the "variation" of "bonding strength" between the first metal layer 14 and the metal base 20 comparing with the second reference example.

Furthermore, according to the first embodiment, abrasion loss of the probe pin 32 also can be suppressed in comparison with the second reference example.

For example, when the friction stir welding is used for the heterogeneous bonding of the metals such as Cu and Al, the probe pin 32 is run into one of the two metals, which has lower melting temperature and has lower hardness.

In the second reference example, the probe pin 32 is also run into the first metal layer 14 that has hardness higher than the metal base 20. Thus, the probe pin 32 is easily worn out.

In contrast, as the second metal layer 15 is provided in the first embodiment, it is possible to reduce the possibility of the probe pin 32 running into the first metal layer 14 in comparison with the second reference example. When the second metal layer 15 is, for example, the same metal as the metal base 20, the hardness is the same as each other. Thus, according to the first embodiment, the abrasion loss of the probe pin 32 can be suppressed in comparison with the second reference example.

### (Second embodiment)

For example, the whole members including a bonding portion must be heated in the "solder bonding". In the "solder bonding", the whole the substrate 10 is heated, for example, on which the first metal layer 14 is provided. The heating temperature is about 300°C. Thus, when the semiconductor device 11 is bonded to the substrate 10, for example, the semiconductor device 11 is also heated at the temperature of about 300°C. There is a demand for the semiconductor device 11 that heat applied during the manufacturing (thermal history) of the semiconductor module 100 is preferably reduced to be as low as possible. However, it is difficult to reduce the thermal history in the "solder bonding" in which the whole substrate 10 is heated.

In contrast, it is possible in the "friction stir welding" to locally heat the bonding portion. Thereby, the "friction stir welding" has the advantage of easily reducing the thermal history of the semiconductor device 11 in comparison with the "solder bonding".

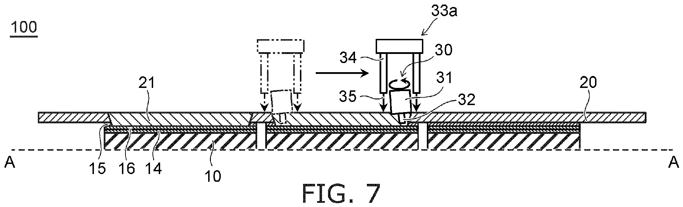

FIG. 7 is a schematic cross-sectional view illustrating one method for manufacturing a semiconductor module according to the second embodiment. The cross section shown in FIG. 7 corresponds to the cross section shown in FIG. 3D.

As shown in FIG. 7, the difference in the second embodiment from the first embodiment shown in FIG. 3D is, for example, in cooling around the friction stir welding tool 30 in the friction stir welding.

The friction stir welding tool 30a of the second embodiment includes, for example, a cooling mechanism 33a around the shoulder 31. The cooling mechanism 33a includes a cooling gas nozzle 34. The cooling gas nozzle 34 blows out a cooling gas 35, for example, toward the probe pin 32.

The cooling mechanism 33a moves together with the friction stir welding tool 30a. Thereby, the cooling mechanism 33a can cool around the bonding portion.

According to such a second embodiment, the cooling mechanism 33a cools around the bonding portion of the substrate 10. Thereby, the friction stir welding can be performed while cooling the substrate 10. Thus, when the friction stir welding process is performed for the substrate 10 to which the semiconductor device 11 is bonded, it is possible to achieve the advantage of further reducing the thermal history of the semiconductor device 11 in comparison with the case in which the substrate 10 is not cooled.

### (Third embodiment)

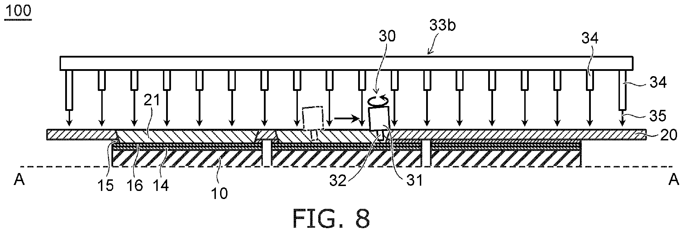

FIG. 8 is a schematic cross-sectional view illustrating one method for manufacturing a semiconductor module according to a third embodiment. The cross section shown in FIG. 8 corresponds to the cross section shown in FIG. 7.

As shown in FIG. 8, the difference in the third embodiment from the second embodiment shown in FIG. 7 is in a cooling mechanism 33b provided on the whole moving range of the friction stir welding tool 30. The cooling mechanism 33b also includes the cooling gas nozzles 34 in the same manner with the cooling mechanism 33a. The cooling gas nozzles 34 are arranged with a gap over the whole moving range of the friction stir welding tool 30.

Also in such a third embodiment, the friction stir welding process can be performed while cooling the substrate 10. Thus, when the friction stir welding process is performed for the substrate 10 to which the semiconductor device 11 is bonded, for example, it is possible in the same manner with the second embodiment to achieve the advantage of further reducing the thermal history of the semiconductor device 11 in comparison with the case in which the substrate 10 is not cooled.

Furthermore, as the cooling mechanism 33b can cool the whole moving range of the friction stir welding tool 30, the unit module UM including the substrate 10 can be cooled before and after the friction stir welding tool 30 moves. Thus, it is possible to further reduce the thermal history of the semiconductor device 11.

### (Fourth embodiment)

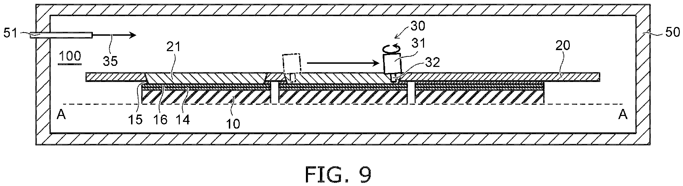

FIG. 9 is a schematic cross sectional view illustrating one method for manufacturing a semiconductor module according to a fourth embodiment. The cross section shown in FIG. 9 corresponds to the cross section shown in FIG. 7.

As shown in FIG. 9, the difference in the fourth embodiment from the second embodiment is in the friction stir welding performed in a chamber 50.

A cooling gas blower 51 is provided in the chamber 50. The cooling gas blower 51 blows a cooling gas 35 into the chamber 50. The friction stir welding process in the fourth embodiment is performed in the cooled chamber 50. Also, in the chamber 50 configured to cool the inside thereof, the substrate 10 is cooled.

Also in such a fourth embodiment, when the friction stir welding process is performed for the substrate 10 to which the semiconductor device 11 is bonded, it is possible in the same manner with the second and third embodiments to further reduce the thermal history of the semiconductor device 11 in comparison with the case in which the substrate 10 is not cooled.

Similar to the fourth embodiment, the friction stir welding may be performed in the cooled chamber 50. The fourth embodiment may be performed in combination with the second embodiment or the third embodiment.

As described above, the first to fourth embodiments have been described. However, an embodiment is not limited to the first to fourth embodiments described above. Those embodiments have been presented as one example, and not intended to limit the scope of the invention. Those novel embodiments are possible to be executed in other various aspects. Various omissions, replacements, and modifications can be made to the extent that the purports of invention are included.

For example, in the embodiments, the specific examples of material are shown with respect to the metal base 20, the first metal layer 14, the second metal layer 15, and the third metal layer 16. However, it is possible to change appropriately the materials of the metal base 20, the first metal layer 14, the second metal layer 15, and the third metal layer 16.

For example, the embodiments describe the examples using the friction stir welding. However, it is also possible to use the "point" welding by the friction stirring.

## Claims

1. A semiconductor module (100) comprising:
a semiconductor device (11);
a metal base (20) including a stirring part (21);
a substrate (10) positioned between the semiconductor device (11) and the metal base (20); and
a metal layer positioned between the metal base (20) and the substrate (10), the metal layer contacting the stirring part (21).

2. The semiconductor module (100) according to claim 1, wherein the metal layer includes
a first metal layer (14) positioned between the metal base (20) and the substrate (10), the first metal layer (14) including first metal, and
a second metal layer (15) positioned between the metal base (20) and the first metal layer (14), the second metal layer (14) contacting the stirring part (21), the second metal layer (15) including second metal different from the first metal, and
the metal base (20) includes metal same as the second metal.

3. The semiconductor module (100) according to claim 2, wherein the second metal has a melting point lower than a melting point of the first metal, or a melting point of alloy including the first metal.

4. The semiconductor module (100) according to claim 2, wherein the second metal has hardness lower than hardness of the first metal, or hardness of alloy including the first metal.

5. The semiconductor module (100) according to claim 2, wherein the metal layer further includes a third metal layer (16) positioned between the first metal layer (14) and the second metal layer (15), the third metal layer (16) including a third metal different from the first metal and the second metal.

6. The semiconductor module (100) according to claim 1, wherein the metal base (20) has a specific gravity smaller than a specific gravity of copper.

7. The semiconductor module (100) according to claim 1, wherein the metal base (20) has a thermal conductivity lower than a thermal conductivity of copper.

8. The semiconductor module (100) according to any one of claims 1 to 7, wherein the metal base (20) has a smooth outer surface (20a), the stirring part (21) being exposed at the outer surface (20a).

9. A method for manufacturing a semiconductor module (100),
the semiconductor module (100) comprising a substrate (10), a semiconductor device (11) and a first metal layer (14), the substrate (10) including a device mounting surface (12a) and a back surface (12b), the semiconductor device (11) being provided on the device mounting surface (12a), the first metal layer (14) being provided on the back surface (12b) and including a first metal,
the method comprising:
providing a metal base (20) contacting the first metal layer (14), the metal base (20) including a second metal different from the first metal;
welding the metal base (20) to the first metal layer (14) by friction stirring using a friction stir welding tool (30) running into the metal base (20) toward the first metal layer (14); and
grinding the metal base (20) on a side where a stirred part (21) are formed.

10. The method for manufacturing the semiconductor module (100) according to claim 9, wherein the welding is performed while cooling the substrate (10).
